# FASCICULE DE BREVET EUROPEEN

(11) **EP 2 261 171 B1**
(45) Date de publication et mention de la délivrance du brevet: **21.11.2012**
(21) Numéro de dépôt: 10163789.0
(22) Date de dépôt: 25.05.2010
(51) Int. Cl.: B81B 3/00, B81C 99/00, B29C 33/38, C25D 1/10, C25D 1/00, C25D 1/20, C25D 5/02, G03F 7/00, G04B 13/02, G04D 3/00

(54) **Procédé de fabrication d'une pièce de micromécanique composite**
Herstellungsverfahren für ein mikromechanisches Verbundbauteil
Method for manufacturing a composite micromechanical part

(30) Priorité: 09.06.2009 EP 09162292
(43) Date de publication de la demande: 15.12.2010
(60) Demande divisionnaire: 12172452.0
(73) Titulaire: Nivarox-FAR S.A., 2400 Le Locle (CH)
(72) Inventeur: Cusin, Pierre, 1423, Villars-Burquin (CH); Thiébaud, Jean-Philippe, 1588, Cudrefin (CH)
(74) Mandataire: Couillard, Yann Luc Raymond

(56) Documents cités:
- EP-A- 2 060 534
- WO-A1-2007/000271
- JP-A- 2005 256 110
- FEI WANG ET AL: "Microcantilever Probe Cards With Silicon and Nickel Composite Micromachining Technique for Wafer-Level Burn-In Testing" IEEE TRANSACTIONS ON ADVANCED PACKAGING, IEEE SERVICE CENTER, PISCATAWAY, NJ, US, vol. 32, no. 2, 1 mai 2009 (2009-05-01), pages 468-477, XP011257226 ISSN: 1521-3323

## Description

### Domaine de l'invention

L'invention se rapporte à la production d'une pièce de micromécanique composite dont au moins une face est à faible coefficient de frottement ainsi que son procédé de fabrication.

### Arrière plan de l'invention

Le document EP 2 060 534 divulgue un procédé de fabrication d'une pièce de micromécanique composite en silicium et métal obtenue à partir de photolithographies de résines photosensibles, de gravages de silicium et de croissances galvaniques. Cependant, un tel procédé est complexe à mettre en oeuvre pour des parties en métal sur plusieurs niveaux et il est nécessaire de prévoir des étapes finales de revêtement pour améliorer les caractéristiques tribologiques du silicium.

De plus, un tel procédé n'est pas adapté pour des pièces de micromécanique à grand élancement où un matériau tel que le nickel - phosphore à, par exemple, 12% de phosphore à tendance au décollement. En effet, les dépôts galvaniques de ce type de pièces délaminent en raison des contraintes internes du nickel - phosphore déposé.

### Résumé de l'invention

Le but de la présente invention est de pallier tout ou partie les inconvénients cités précédemment en proposant un procédé de fabrication d'une pièce de micromécanique composite qui comporte moins d'étapes.

A cet effet, l'invention se rapporte à un procédé de fabrication d'une pièce de micromécanique composite comportant les étapes suivantes :
a) se munir d'un substrat comportant une couche horizontale supérieure et une couche horizontale inférieure en matériau micro-usinable électriquement conductrices et solidarisées entre elles par une couche horizontale intermédiaire électriquement isolante ;
b) graver selon au moins un motif dans la couche supérieure jusqu'à la couche intermédiaire afin de former au moins une cavité dans le substrat destinée à former au moins une partie en matériau micro-usinable de la pièce composite ;
c) recouvrir la partie supérieure dudit substrat d'un revêtement électriquement isolant ;
d) graver de manière directionnelle ledit revêtement et ladite couche intermédiaire afin de limiter leur présence uniquement au niveau de chaque paroi verticale formée dans la couche supérieure en découvrant le dessus de la couche supérieure et le dessus de la couche inférieure au fond de ladite au moins une cavité ;
e) réaliser une électrodéposition en connectant l'électrode à la couche conductrice inférieure du substrat afin de former au moins une partie métallique de la pièce composite ;
f) libérer la pièce composite du reste du substrat.

Ainsi, avantageusement selon l'invention, le dépôt de la couche tribologiquement meilleure que le matériau micro-usinable est entièrement intégrée au procédé de fabrication et non effectuée a posteriori de la fabrication de ladite pièce.

Conformément à d'autres caractéristiques avantageuses de l'invention :
- une pièce est montée après l'étape d) au-dessus de la couche supérieure afin de former au moins un évidement communiquant avec ladite au moins une cavité afin de former un deuxième niveau à ladite pièce ;
- le procédé comporte, avant l'étape e), l'étape g) : monter une tige dans ladite au moins une cavité afin de former un trou dans la future pièce composite ;
- l'étape b) comporte les phases h) : structurer au moins un masque de protection sur la couche conductrice supérieure, i) : réaliser une attaque anisotrope de ladite couche supérieure selon les parties non recouvertes par ledit au moins un masque de protection, j) : retirer ledit au moins masque de protection ;
- le procédé comporte, avant l'étape e), l'étape g) : monter une tige dans ladite au moins une cavité afin de former un trou dans la future pièce composite ;
- le procédé comporte, avant l'étape f), les étapes b') : graver selon un motif dans la couche inférieure jusqu'à ladite partie métallique afin de former au moins une deuxième cavité dudit substrat, c') : recouvrir la partie inférieure dudit substrat d'un deuxième revêtement électriquement isolant, e') : réaliser une électrodéposition en connectant l'électrode à la couche conductrice inférieure du substrat afin de finir la formation des parties métalliques de ladite pièce ;
- le procédé comporte, à la suite de l'étape c'), l'étape d') : graver de manière directionnelle ledit deuxième revêtement afin de découvrir uniquement le dessous de la couche inférieure ;
- une pièce est montée après l'étape d') afin de former au moins un évidement communiquant avec ladite au moins une deuxième cavité offrant un deuxième niveau supplémentaire à ladite pièce ;
- le procédé comporte, avant l'étape e'), l'étape g') : monter une tige dans ladite au moins une deuxième cavité de la couche inférieure afin de former un trou dans la future pièce composite ;
- l'étape b') comporte les phases h') : structurer au moins un masque de protection sur la couche conductrice inférieure, i') : réaliser une attaque anisotrope de ladite couche inférieure selon les parties non recouvertes par ledit au moins un masque de protection, j') : retirer le masque de protection ;
- plusieurs pièces de micromécanique composite sont fabriquées sur le même substrat.
- les couches conductrices comportent un matériau à base de silicium dopé.

### Description sommaire des dessins

D'autres particularités et avantages ressortiront clairement de la description qui en est faite ci-après, à titre indicatif et nullement limitatif, en référence aux dessins annexés, dans lesquels :
- les figures 1 à 6 sont des représentations des étapes successives d'un procédé de fabrication d'une pièce de micromécanique selon un premier mode de réalisation de l'invention ;
- la figure 7 est une pièce de micromécanique
   qui peut être produite par un procédé selon l'invention;
- les figures 8 à 13 sont des représentations des étapes successives d'un procédé de fabrication d'une pièce de micromécanique selon un deuxième mode de réalisation de l'invention ;
- la figure 14 est un schéma fonctionnel d'un procédé de fabrication d'une pièce de micromécanique selon l'invention.

### Description détaillée des modes de réalisation préférés

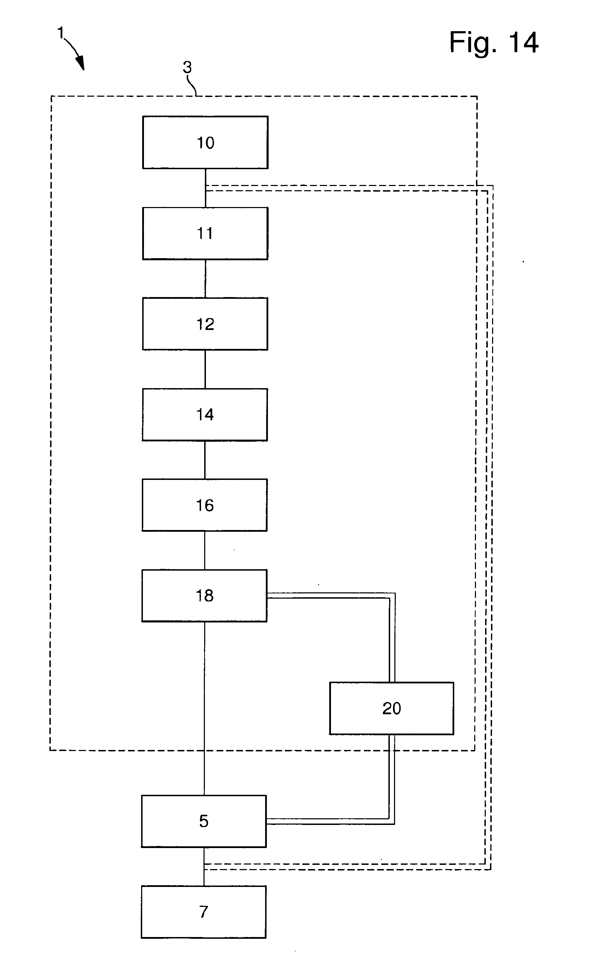

Comme visible à la figure 14, l'invention se rapporte à un procédé de fabrication 1 d'une pièce de micromécanique composite 41, 41'. Le procédé 1 comporte, préférentiellement, un procédé de préparation 3 suivi des étapes de galvanoplastie 5 et de libération 7 de la pièce composite 41, 41' ainsi formée.

Le procédé de préparation 3 comporte des étapes successives destinées à préparer un substrat 9, 9' en matériau au moins partiellement micro-usinable comme, préférentiellement, des matériaux à base de silicium. Le procédé de préparation 3 est destiné à faciliter la réception et la croissance de l'étape 5 de dépôt galvanique.

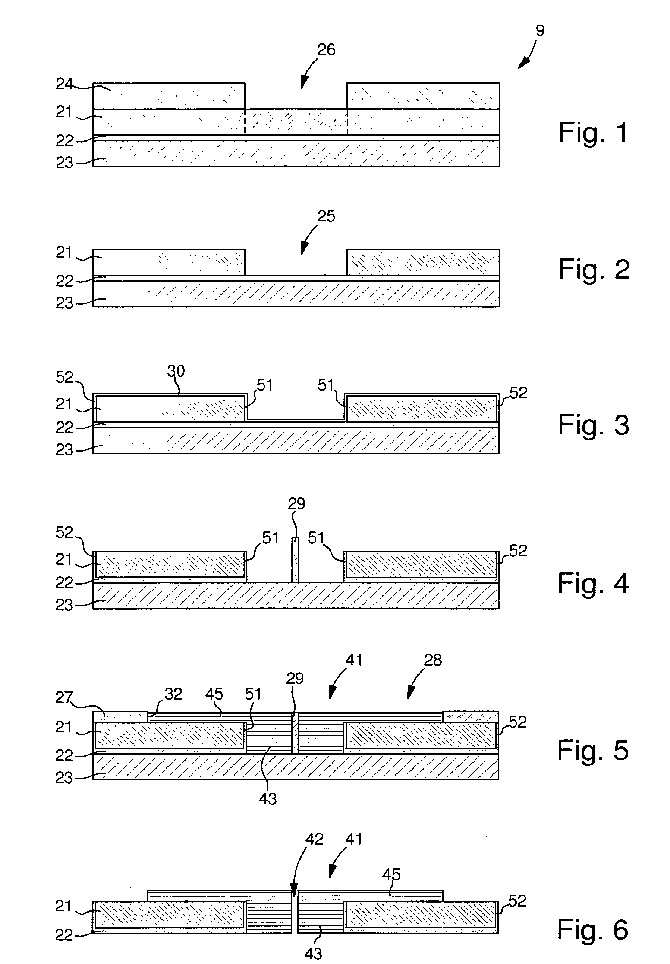

Une première étape 10 du procédé 3 consiste à se munir d'un substrat 9 comportant une couche supérieure 21 et une couche inférieure 23, en matériau micro-usinable électriquement conducteur, solidarisées entre elles par une couche intermédiaire 22 électriquement isolante comme illustré à la figure 1.

Préférentiellement, le substrat 9 est un S.O.I. (abréviation très connue provenant des termes anglais « Silicon On Isulator »). Ainsi, la couche intermédiaire 22 est préférentiellement en dioxyde de silicium. De plus, les couches supérieure 21 et inférieure 23 sont en silicium cristallin suffisamment dopé afin que lesdites couches soient électriquement conductrices.

Selon l'invention, le procédé 3 comporte une deuxième étape 11, consistant à structurer au moins un masque 24 de protection sur la couche conductrice supérieure 21 comme illustré à la figure 1. Comme visible également à la figure 1, le masque 24 comporte au moins un motif 26 qui ne recouvre pas la couche supérieure 21. Un tel masque 24 peut, par exemple, être obtenu par photolithographie à l'aide d'une résine photosensible du type positif ou négatif.

Dans une troisième étape 12, la couche supérieure 21 est gravée jusqu'à découvrir la couche intermédiaire 22. Selon l'invention, l'étape 12 de gravage comporte, de manière préférée, une attaque sèche anisotrope du type gravage ionique réactif profond (DRIE). L'attaque anisotrope est effectuée dans la couche supérieure 21 selon le motif 26 du masque 24.

Dans une quatrième étape 14, le masque 24 est retiré. Ainsi, comme visible à la figure 2, à la fin de la quatrième étape 14, la couche supérieure 21 est gravée sur toute son épaisseur d'au moins une cavité 25, permettant de former une partie en silicium d'au moins une pièce composite finale 41, 41 '.

Dans une cinquième étape 16, un revêtement 30 électriquement isolant est déposé en recouvrant l'ensemble supérieur du substrat 9 comme illustré à la figure 3. Préférentiellement, le revêtement 30 est obtenu par oxydation du dessus de la couche supérieure 21 gravée et de la couche intermédiaire 22. Comme visible à la figure 3, on obtient donc une couche de dioxyde de silicium aussi bien sur le dessus de la couche supérieure 21 et de la couche intermédiaire 22 mais également sur les parois verticales 51, 52 de la couche supérieure 21.

Selon une sixième étape 18, un gravage directionnel du revêtement 30 et de la couche intermédiaire 22 est réalisé. L'étape 18 est destinée à limiter la présence de couches isolantes uniquement au niveau de chaque paroi verticale formée dans la couche supérieure 21, c'est-à-dire les parois 51, 52 respectivement de l'extérieure de la future pièce composite 41, 41 ' et de ladite au moins une cavité 25. Selon l'invention, lors d'un gravage directionnel ou anisotrope, la composante verticale du phénomène de gravure est favorisée par rapport à la composition horizontale, en modulant, par exemple, la pression dans la chambre (travail à pression très basse), dans un réacteur de gravage du type ionique réactif. Un tel gravage peut, à titre d'exemple, être du type « ion milling » ou « sputter etching ». En réalisant cette étape 18 et comme illustré à la figure 4, on comprend que le fond de la cavité 25 est formé par la couche inférieure 23 électriquement conductrice et, le dessus du substrat 9, par la couche supérieure 21 également conductrice.

Afin d'améliorer l'accrochage de la future galvanoplastie de l'étape 5, une couche d'accrochage sur le fond de chaque cavité 25 et/ou sur le dessus de la couche supérieure 21 peut être prévue. La couche d'accrochage pourrait alors consister en un métal comme de l'alliage CrAu.

De manière préférée, lors de la sixième étape 18, une tige 29 peut également être montée afin de former directement un trou d'axe 42, 42' de la pièce de micromécanique composite 41, 41' lors de l'étape 5 de galvanoplastie. Cela présente l'avantage non seulement de ne pas à avoir à usiner la pièce 41, 41' une fois la galvanoplastie terminée mais également de pouvoir réaliser n'importe quelle forme de section intérieure, de manière uniforme ou non, sur toute la hauteur du trou 42, 42'. Préférentiellement, la tige 29 est obtenue, par exemple, à l'aide d'un procédé de photolithographie d'une résine photosensible.

A la suite de l'étape 18, le procédé de préparation 3 est terminé et le procédé de fabrication 1 de la pièce de micromécanique composite se poursuit par les étapes de galvanoplastie 5 et de libération 7 de ladite pièce.

L'étape 5 de galvanoplastie est réalisée en connectant l'électrode de dépôt à la couche inférieure 23 afin de faire croître un dépôt électrolytique 33 dans la cavité 25.

Le procédé de fabrication 1 se termine par l'étape 7 dans laquelle la pièce formée par la couche supérieure 21 et la partie métallique déposée dans la cavité 25 est libérée du reste du substrat 9, c'est-à-dire de la couche inférieure 23 et de la tige 29. Selon ce mode de réalisation, on comprend que la pièce de micromécanique obtenue comporte un seul niveau de forme identique selon toute son épaisseur et pouvant comporter un trou d'axe.

Une telle pièce de micromécanique pourrait, par exemple, être une roue d'échappement, une ancre d'échappement ou même un pignon comportant une partie métallique au niveau de son trou d'axe apte à chasser ladite pièce de micromécanique. De plus, la paroi extérieure de la partie silicium comporte une couche de dioxyde de silicium aux caractéristiques plus avantageuses que celles de la partie en silicium 21 et offrant une précision géométrique de l'ordre du micromètre.

Selon une alternative à ce mode de réalisation illustré par un trait double à la figure 14, à la suite de l'étape 18, le procédé de préparation 3 comporte une étape supplémentaire 20 destinée à former au moins un deuxième niveau 45, 45' à la partie métallique 43, 43' comme illustré à la figure 5. Ainsi, le deuxième niveau 45, 45' est réalisé en montant une pièce 27, comportant des parois 32 électriquement isolantes, sur la couche supérieure 21 qui n'a pas été gravée lors de l'étape 12.

Préférentiellement, la pièce 27 ajoutée forme au moins un évidement 28 de section plus grande que les parties retirées selon le motif 26, par exemple, à l'aide d'un procédé de photolithographie d'une résine photosensible. Cependant, la pièce 27 pourrait également comporter un matériau à base de silicium préalablement gravé puis être solidarisée sur la couche conductrice 21.

Par conséquent, selon l'alternative du mode de réalisation ci-dessus, à la suite de l'étape 20, le procédé de préparation 3 est terminé et le procédé de fabrication 1 de la pièce de micromécanique composite 41 se poursuit par les étapes de galvanoplastie 5 et de libération 7 de ladite pièce du substrat 9.

L'étape 5 de galvanoplastie est réalisée en connectant l'électrode de dépôt à la couche inférieure 23 afin de faire croître dans un premier temps un dépôt électrolytique dans la cavité 25 puis, seulement dans un deuxième temps, dans l'évidement 28 comme illustré à la figure 5.

En effet, avantageusement selon l'invention, lorsque le dépôt électrolytique affleure de la partie supérieure de la cavité 25, il connecte électriquement la couche supérieure 21 (ou, éventuellement, sa couche d'accrochage) ce qui permet une croissance horizontale homogène du dépôt dans l'ensemble de l'évidement 28. Ainsi, l'invention permet la réalisation de pièces composites 41 comportant une première partie 43 en métal selon la même épaisseur que la couche supérieure 21 et une deuxième partie métallique 45 en saillie.

De manière avantageuse, la deuxième partie métallique 45 peut être à grand élancement, c'est-à-dire que la section de la cavité 25 peut être beaucoup plus petite que celle de l'évidement 28. En effet grâce au procédé 1, la partie 45 est fabriquée en évitant les problèmes de décollement y compris avec un matériau déposé comme du nickel - phosphore à, par exemple, 12% de phosphore. Cet effet avantageux est dû en partie à l'utilisation du silicium comme couches conductrices 21, 23 (et éventuellement leur couche d'accrochage) qui diminue les phénomènes de délamination aux interfaces.

Selon l'alternative du mode de réalisation ci-dessus, le procédé de fabrication 1 se termine par l'étape 7, dans laquelle la pièce 41 formée est libérée, c'est-à-dire que la pièce 27 et la tige 29 sont enlevées et la pièce 41 retirée des couches 22, 23 du substrat 9.

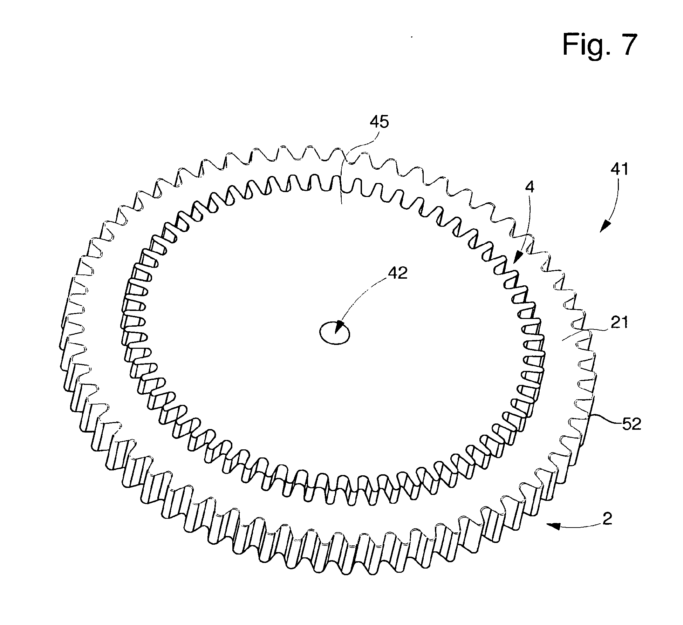

On comprend comme illustré aux figures 6 et 7 que la pièce de micromécanique composite 41 obtenue comporte deux niveaux, chacun de forme différente selon une épaisseur parfaitement indépendante et pouvant comporter un unique trou d'axe 42. Le premier niveau comporte ainsi la couche supérieure 21 dont les parois verticales 51, 52 sont recouvertes de dioxyde de silicium et dont la cavité interne 25 reçoit une première partie 43 du dépôt galvanique. Le deuxième niveau est uniquement réalisé par la deuxième partie métallique 45 s'étendant en prolongement de la première partie 43 et en saillie de la couche supérieure 21. Dans l'exemple illustré aux figures 6 et 7, on remarque que la deuxième partie 45 est également en recouvrement partiel de la couche supérieure 21.

Comme visible aux figures 6 et 7, la pièce de micromécanique 41 peut par conséquent avoir le même premier niveau que celui obtenu par le mode de réalisation sans l'étape 20 et ainsi comporter une précision géométrique de l'ordre du micromètre mais également un référencement idéal c'est-à-dire un positionnement parfait entre les deux niveaux. La pièce de micromécanique 41 peut dès lors former un mobile comportant une roue dentée 2 et un pignon 4 comme, par exemple, une roue d'échappement. Selon l'invention, la pièce de micromécanique obtenue n'est pas limitée à un mobile. En variante, il est parfaitement envisageable d'obtenir une ancre 2 avec des palettes monoblocs à revêtement de dioxyde de silicium comportant un dard 4.

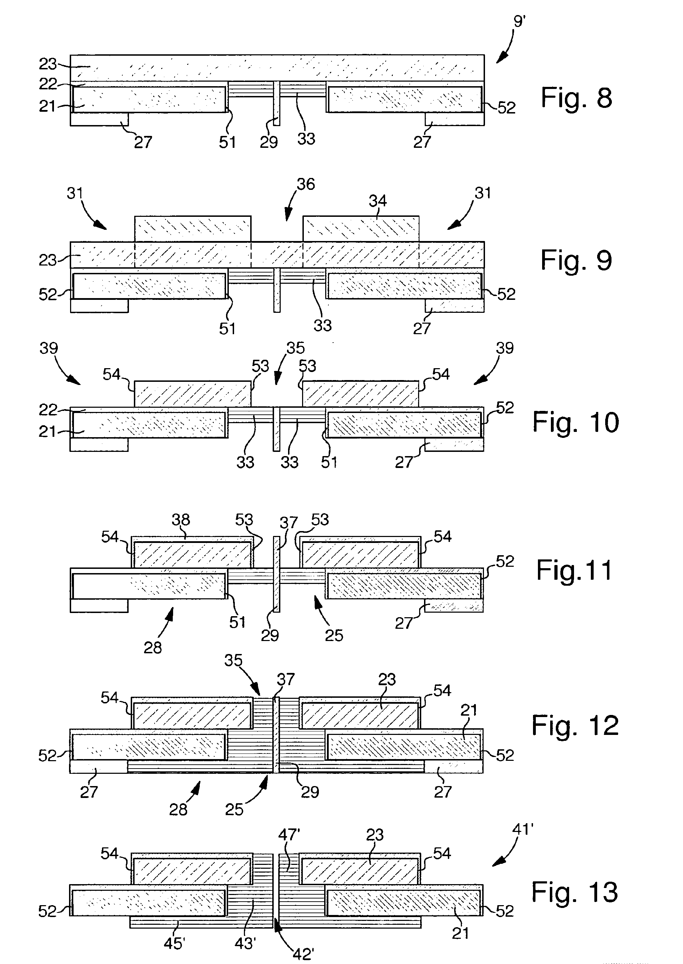

Selon un deuxième mode de réalisation du procédé 1 (illustrée en traits doubles discontinus à la figure 14) représentant pour partie une continuation du mode de réalisation déjà exposé. Comme illustré aux figures 8 à 13, il est ainsi possible d'appliquer le procédé 3 également à la couche inférieure 23 afin de rajouter au moins un ou deux autres niveaux supplémentaires à ladite pièce de micromécanique. Afin de ne pas surcharger les figures, un seul exemple est détaillé ci-dessus mais on comprend que la couche inférieure 23 peut également être transformée selon le mode de réalisation exposé ci-dessus avec, ou non, son alternative.

Les étapes du deuxième mode de réalisation restent identiques ou similaires au procédé 1 décrit ci-dessus jusqu'à l'étape 18 ou 20. Dans l'exemple illustré aux figures 8 à 13, on prendra comme point de départ du procédé 1, l'exemple du mode de réalisation avec l'alternative de l'étape 20 comme illustré à la figure 5.

Préférentiellement selon ce deuxième mode de réalisation, la couche inférieure 23 est destinée à être gravée afin de former au moins une deuxième cavité 35. Comme visible, de manière préférée entre la figure 5 et la figure 8, un dépôt 33 a été réalisé dans une partie de la première cavité 25 afin de fournir une couche de départ pour la deuxième galvanoplastie. Préférentiellement, ce dépôt 33 est effectué en commençant l'étape 5 jusqu'à une épaisseur prédéterminée. Cependant, ce dépôt 33 peut être effectué selon un autre procédé.

Comme illustré par des traits double discontinus à la figure 14 et les figures 8 à 13, le deuxième mode de réalisation du procédé 1 applique à la couche inférieure 23, les étapes 11, 12, 14, 16 et 18 du premier mode de réalisation du procédé 3 expliqué ci-dessus.

Ainsi selon le deuxième mode de réalisation, le procédé 3 comporte une nouvelle étape 11, consistant à structurer au moins un masque 34 sur la couche conductrice inférieure 23 du substrat 9' comme illustré à la figure 9. Comme visible également à la figure 9, le masque 34 comporte au moins un motif 36 et 31 qui ne recouvre pas la couche inférieure 23. Un tel masque 34 peut, par exemple, être obtenu par photolithographie à l'aide d'une résine photosensible.

Ensuite, à la nouvelle étape 12, la couche 23 est gravée selon les motifs 36 et 31 jusqu'à découvrir le dépôt 33 électriquement conducteur et la couche intermédiaire 22. Puis le masque de protection 34 est retiré lors d'une nouvelle étape 14. Ainsi, comme visible à la figure 10, à la fin de l'étape 14, la couche inférieure 23 est gravée sur toute son épaisseur d'au moins une cavité 35 et 39.

Dans une nouvelle étape 16, un revêtement 38 électriquement isolant est déposé en recouvrant l'ensemble inférieur du substrat 9' comme illustré à la figure 11. Préférentiellement, le revêtement 38 est obtenu par dépôt d'un dioxyde de silicium sur le dessous de la couche inférieure 23, par exemple, à l'aide d'un dépôt physique en phase vapeur.

Préférentiellement, dans notre exemple des figures 8 à 13, une nouvelle étape 18 n'est effectuée que pour enlever la couche d'oxyde présente dans le fond de ladite au moins une cavité 35. Cependant, dans le cas où un deuxième niveau est souhaité, un gravage directionnel de toutes les partie horizontales du revêtement 38 est réalisé. La nouvelle étape 18 serait alors destinée à limiter la présence de couche isolante uniquement au niveau de chaque paroi verticale 53, 54 formée dans la couche inférieure 23, c'est-à-dire les parois de l'extérieure de la future pièce 41' et de ladite au moins une cavité 35.

Lors de la nouvelle étape 18, comme expliqué précédemment, une tige 37 peut être montée afin de former directement le trou d'axe 42' de la pièce de micromécanique 41' lors de l'étape 5 de galvanoplastie avec les mêmes avantages que cités précédemment.

Dans le deuxième mode de réalisation du procédé 1, à la suite de l'étape 18, le procédé de préparation 3 est terminé et le procédé de fabrication 1 de la pièce de micromécanique se poursuit par les étapes de galvanoplastie 5 et de libération 7 de la pièce composite 41'. Préférentiellement, si les tiges 29 et 37 sont formées respectivement dans les cavités 25 et 35, elles sont alignées. De plus, la tige 37 est, de manière préférée, obtenue à l'aide d'un procédé de photolithographie d'une résine photosensible.

A la suite de la nouvelle étape 18 (ou 20), l'étape 5 de galvanoplastie est réalisée en connectant l'électrode de dépôt à la couche inférieure 23 afin de faire croître un dépôt électrolytique dans la cavité 35 mais également continuer la croissance du dépôt dans la cavité 25, puis, seulement dans un deuxième temps, dans l'évidement 28 comme illustré à la figure 12. Dans le cas de l'exemple illustré à la figure 12 afin de connecter ladite électrode, il est ainsi par exemple possible de graver une partie de la couche de dioxyde de silicium 38 contenue au-dessous de la surface supérieure 23 afin d'y accéder. Il peut également être envisager de connecter directement le dépôt 33.

Le procédé de fabrication 1 selon le deuxième mode de réalisation se termine par l'étape 7, dans laquelle la pièce 41' est libérée, c'est-à-dire que la pièce 27 et les tiges 29, 37 sont enlevées et la pièce 41' retirée du substrat 9'.

Selon ce deuxième mode de réalisation, on comprend comme illustré à la figure 13 que la pièce de micromécanique composite 41' obtenue comporte au moins trois niveaux, chacun de forme différente selon une épaisseur parfaitement indépendante avec un trou d'axe unique 42'. Le premier niveau comporte ainsi la couche supérieure 21 dont les parois verticales 51, 52 sont recouvertes de dioxyde de silicium dont la cavité interne 25 reçoit une première partie 43' du dépôt galvanique. Le deuxième niveau est uniquement réalisé par la deuxième partie métallique 45' s'étendant en prolongement de la première partie 43' et en saillie de la couche supérieure 21. Enfin, le troisième niveau est formé par la couche inférieure 23 dont les parois verticales 53, 54 sont recouvertes de dioxyde de silicium et dont la cavité interne 35 reçoit une troisième partie 47' du dépôt galvanique.

La pièce de micromécanique 41' peut par conséquent avoir les deux mêmes premiers niveaux que celui obtenu par le premier mode de réalisation avec l'étape 20. Une telle pièce de micromécanique 41' pourrait, par exemple, être une roue d'échappement coaxiale 21 - 52, 23 - 54 avec son pignon 45' ou un mobile à trois niveaux de dentures 21 - 52, 23 - 54, 45' comportant une précision géométrique de l'ordre du micromètre mais également un référencement idéal c'est-à-dire un positionnement parfait entre lesdits niveaux.

Bien entendu, la présente invention ne se limite pas à l'exemple illustré mais est susceptible de diverses variantes et modifications qui apparaîtront à l'homme de l'art. Ainsi, plusieurs pièces de micromécanique composite 41, 41' peuvent être fabriquées sur le même substrat 9, 9' afin de réaliser une production en série de pièces de micromécanique 41, 41' qui ne sont pas forcément identiques entre elles. De même, on peut également envisager changer des matériaux à base de silicium par de l'alumine cristallisée ou de la silice cristallisée ou carbure de silicium. Il est également envisageable que les dépôts isolants 30 et/ou 38 soient de nature différente et/ou qu'ils soient déposés chacun selon des méthodes différentes que celles exposées ci-dessus.

## Revendications

1. Procédé de fabrication (1) d'une pièce de micromécanique composite (41, 41') comportant les étapes suivantes :
a) se munir (10) d'un substrat (9, 9') comportant une couche horizontale supérieure (21) et une couche horizontale inférieure (23) en matériau micro-usinable électriquement conductrices et solidarisées entre elles par une couche horizontale intermédiaire (22) électriquement isolante ;
b) graver selon au moins un motif (26) dans la couche supérieure (21) jusqu'à la couche intermédiaire (22) afin de former au moins une cavité (25) dans le substrat (9, 9') destinée à former au moins une partie en matériau micro-usinable (21, 23) de la pièce composite ;
c) recouvrir (16) la partie supérieure dudit substrat d'un revêtement (30) électriquement isolant ;
d) graver (18) de manière directionnelle ledit revêtement et ladite couche intermédiaire afin de limiter la présence du revêtement uniquement au niveau de chaque paroi verticale (51, 52) formée dans la couche supérieure (21) en découvrant le dessus de la couche supérieure (21) et le dessus de la couche inférieure (23) au fond de ladite au moins une cavité ;
e) réaliser (5) une électrodéposition en connectant l'électrode à la couche conductrice inférieure (23) du substrat (9, 9') afin de former au moins une partie métallique (33, 43, 43') de la pièce composite :
f) libérer la pièce composite (41, 41') du reste du substrat (9, 9').

2. Procédé (1) selon la revendication 1, **caractérisé en ce qu'**une pièce (27) est montée après l'étape d) au-dessus de la couche supérieure (21) afin de former au moins un évidement (28) communiquant avec ladite au moins une cavité afin de former un deuxième niveau (45, 45') à ladite pièce.

3. Procédé (1) selon la revendication 1 ou 2, **caractérisé en ce qu'**il comporte, avant l'étape e), l'étape suivante :
g) monter une tige (29) dans ladite au moins une cavité afin de former un trou (42, 42') dans la future pièce composite (41, 41').

4. Procédé (1) selon l'une des revendications précédentes, **caractérisé en ce que** l'étape b) comporte les phases suivantes :
h) structurer (11) au moins un masque (24) de protection sur la couche conductrice supérieure (21) ;
i) réaliser (12) une attaque anisotrope de ladite couche supérieure selon les parties (26) non recouvertes par ledit au moins un masque de protection ;
j) retirer (14) ledit au moins masque de protection.

5. Procédé (1) selon l'une des revendications précédentes, **caractérisé en ce qu'**il comporte, avant l'étape f), les étapes suivantes :
b') graver selon un motif (36, 31) dans la couche inférieure (23) jusqu'à ladite partie métallique (33, 43, 43') afin de former au moins une deuxième cavité (35) dudit substrat ;
c') recouvrir la partie inférieure (23) dudit substrat d'un deuxième revêtement (38) électriquement isolant ;
e') réaliser une électrodéposition en connectant l'électrode à la couche conductrice inférieure (23) du substrat (9') afin de finir la formation des parties métalliques (33, 43', 45', 47') de ladite pièce.

6. Procédé (1) selon la revendication 5, **caractérisé en ce qu'**il comporte, à la suite de l'étape c'), l'étape suivante :
d')graver (18) de manière directionnelle ledit deuxième revêtement afin de découvrir uniquement le dessous de la couche inférieure (23).

7. Procédé (1) selon la revendication 6, **caractérisé en ce qu'**une pièce est montée après l'étape d') afin de former au moins un évidement communiquant avec ladite au moins une deuxième cavité offrant un deuxième niveau supplémentaire à ladite pièce.

8. Procédé (1) selon l'une des revendications 5 à 7, **caractérisé en ce qu'**il comporte, avant l'étape e'), l'étape suivante :
g') monter une tige (37) dans ladite au moins une deuxième cavité (35) de la couche inférieure (23) afin de former un trou (42') dans la future pièce composite (41').

9. Procédé (1) selon l'une des revendications 5 à 8, **caractérisé en ce que** l'étape b') comporte les phases suivantes :
h') structurer au moins un masque (34) de protection sur la couche conductrice inférieure (23) ;
i') réaliser une attaque anisotrope de ladite couche inférieure selon les parties (36, 31) non recouvertes par ledit au moins un masque de protection ;
j') retirer le masque de protection (34).

10. Procédé (1) selon l'une des revendications précédentes, **caractérisé en ce que** plusieurs pièces de micromécanique composite (41, 41') sont fabriquées sur le même substrat (9, 9').

11. Procédé (1) selon l'une des revendications précédentes, **caractérisé en ce que** les couches conductrices (21, 23) comportent un matériau à base de silicium dopé.

## Claims

1. Method (1) of fabricating a composite micromechanical component (41, 41') including the following steps:
a) providing (10) a substrate (9, 9') that includes a horizontal top layer (21) and a horizontal bottom layer (23) made of electrically conductive, micromachinable material, and secured to each other by an electrically insulating, horizontal, intermediate layer (22);
b) etching at least one pattern (26) in the top layer (21) through to the intermediate layer (22) , so as to form at least one cavity (25) in the substrate (9, 9') that will form at least one part (21, 23), made of micromachinable material, of the composite component;
c) coating (16) the top part of said substrate with an electrically insulating coating (30) ;
d) directionally etching (18) said coating and said intermediate layer so as to limit the presence thereof exclusively at each vertical wall (51, 52) formed in the top layer (21);
e) performing (5) an electrodeposition by connecting the electrode to the conductive bottom layer (23) of the substrate (9, 9') to form at least one metal part (33, 43, 43') of the composite component;
f) releasing the composite component (41, 41') from the substrate (9, 9').

2. Method (1) according to claim 1, **characterized in that** one part (27) is mounted after step d), above the top layer (21), to form at least one recess (28) that communicates with said at least one cavity so as to form a second level (45, 45') of said component.

3. Method (1) according to claim 1 or 2, **characterized in that**, prior to step e), it includes the following step:
g) mounting a pin (29) in said at least one cavity so as to form a hole (42, 42') in the future composite component (41, 41').

4. Method (1) according to any of the preceding claims, **characterized in that** step b) includes the following phases:
h) structuring (11) at least one protective mask (24) on the conductive top layer (21);
i) performing (12) an anisotropic etch of said top layer in the parts (26) that are not covered by said at least one protective mask;
j) removing (14) said at least one protective mask.

5. Method (1) according to any of the preceding claims, **characterized in that**, prior to step f), it includes the following steps:
b') etching a pattern (36, 31) in the bottom layer (23) through to said metal part (33, 43, 43') so as to form at least a second cavity (35) in said substrate;
c') coating the bottom part (23) of said substrate with a second electrically insulating coating (38);
e') performing an electrodeposition by connecting the electrode to the conductive bottom layer (23) of the substrate (9') so as to finish forming the metal parts (33, 43', 45', 47') of said component.

6. Method (1) according to claim 5, **characterized in that**, after step c'), it includes the following step:
d') directionally etching (18) said second coating so as to reveal exclusively the bottom of the bottom layer (23).

7. Method (1) according to claim 6, **characterized in that** a part is assembled after step d') so as to form at least one recess that communicates with said at least one second cavity offering said component an additional second level.

8. Method (1) according to any of claims 5 to 7, **characterized in that**, prior to step e'), it includes the following step:
g') mounting a pin (37) in said at least one second cavity (35) in the bottom layer (23) so as to form a hole (42') in the future composite component (41').

9. Method (1) according to any of claims 5 to 8, **characterized in that** step b') includes the following phases:
h') structuring at least one protective mask (34) on the conductive bottom layer (23);
i') performing an anisotropic etch of said bottom layer in the parts (36, 31) that are not covered by said at least one protective mask;
j') removing the protective mask (34).

10. Method (1) according to any of the preceding claims, **characterized in that** several composite micromechanical components (41, 41') are fabricated on the same substrate (9, 9').

11. Method (1) according to any of the preceding claims, **characterized in that** the conductive layers (21, 23) include a doped silicon-based material.

## Patentansprüche

1. Verfahren (1) für die Herstellung eines mikromechanischen Verbundteils (41, 41'), das die folgenden Schritte umfasst:
a) Vorsehen (10) eines Substrats (9, 9'), das eine obere horizontale Schicht (21) und eine untere horizontale Schicht (23) aus einem elektrisch leitenden, mikrobearbeitbaren Material, die durch eine elektrisch isolierende horizontale Zwischenschicht (22) aneinander befestigt sind, aufweist;
b) Ritzen wenigstens eines Musters (26) in die obere Schicht (21) bis zu der Zwischenschicht (22), um in dem Substrat (9, 9') wenigstens einen Hohlraum (25) zu bilden, der dazu bestimmt ist, wenigstens einen Teil (21, 23) aus mikrobearbeitbarem Material des Verbundteils zu bilden;
c) Bedecken (16) des oberen Teils des Substrats mit einer elektrisch isolierenden Beschichtung (30);
d) gerichtetes Ritzen (18) der Beschichtung und der Zwischenschicht, um das Vorhandensein der Beschichtung ausschließlich auf das Niveau jeder vertikalen Wand (51, 52), die in der oberen Schicht (21) gebildet ist, zu begrenzen, indem die Oberseite der oberen Schicht (21) und die Oberseite der unteren Schicht (23) auf dem Boden des wenigstens einen Hohlraums freigelegt werden;
e) Verwirklichen (5) einer Metallisierung durch Verbinden der Elektrode mit der unteren leitenden Schicht (23) des Substrats (9, 9'), um wenigstens einen metallischen Teil (33, 43, 43') des Verbundteils zu bilden;
f) Befreien des Verbundteils (41, 41') vom Rest des Substrats (9, 9').

2. Verfahren (1) nach Anspruch 1, **dadurch gekennzeichnet, dass** ein Teil (27) nach dem Schritt d) auf der oberen Schicht (21) angebracht wird, um wenigstens eine Aussparung (28) zu bilden, die mit dem wenigstens einen Hohlraum kommuniziert, um ein zweites Niveau (45, 45') in Bezug auf das Teil zu bilden.

3. Verfahren (1) nach Anspruch 1 oder 2, **dadurch gekennzeichnet, dass** es vor dem Schritt e) den folgenden Schritt umfasst:
g) Anbringen eines Stifts (29) in dem wenigstens einen Hohlraum, um in dem künftigen Verbundteil (41, 41') ein Loch (42, 42') zu bilden.

4. Verfahren (1) nach einem der vorhergehenden Ansprüche, **dadurch gekennzeichnet, dass** der Schritt b) die folgenden Phasen umfasst:
h) Strukturieren (11) wenigstens einer Schutzmaske (24) auf der oberen leitenden Schicht (21);
i) Ausführen (12) eines anisotropen Ätzens der oberen Schicht längs der nicht bedeckten Teile (26) durch die wenigstens eine Schutzmaske;
j) Abnehmen (14) der wenigstens einen Schutzmaske.

5. Verfahren (1) nach einem der vorhergehenden Ansprüche, **dadurch gekennzeichnet, dass** es vor dem Schritt f) die folgenden Schritte umfasst:
b') Ritzen längs eines Musters (36, 31) in der unteren Schicht (23) bis zu dem Metallteil (33, 43, 43'), um wenigstens einen zweiten Hohlraum (35) des Substrats zu bilden;
c') Bedecken des unteren Teils (23) des Substrats mit einer zweiten elektrisch isolierenden Beschichtung (38);
e') Verwirklichen einer Metallisierung durch Verbinden der Elektrode mit der unteren leitenden Schicht (23) des Substrats (9'), um die Bildung der Metallteile (33, 43', 45', 47') des Teils zu beenden.

6. Verfahren (1) nach Anspruch 5, **dadurch gekennzeichnet, dass** es nach dem Schritt (c') den folgenden Schritt umfasst:
d') gerichtetes Ritzen (18) der zweiten Beschichtung, um nur die Unterseite der unteren Schicht (23) freizulegen.

7. Verfahren (1) nach Anspruch 6, **dadurch gekennzeichnet, dass** nach dem Schritt d') ein Teil angebracht wird, um wenigstens eine Aussparung zu bilden, die mit dem wenigstens einen zweiten Hohlraum kommuniziert, was ein zweites zusätzliches Niveau in Bezug auf das Teil ergibt.

8. Verfahren (1) nach einem der Ansprüche 5 bis 7, **dadurch gekennzeichnet, dass** es vor dem Schritt e') den folgenden Schritt umfasst:
g') Anbringen eines Stifts (37) in dem wenigstens einen zweiten Hohlraum (35) der unteren Schicht (23), um in dem künftigen Verbundteil (41') ein Loch (42') zu bilden.

9. Verfahren (1) nach einem der Ansprüche 5 bis 8, **dadurch gekennzeichnet, dass** der Schritt b') die folgenden Phasen umfasst:
h') Strukturieren wenigstens einer Schutzmaske (34) auf der unteren leitenden Schicht (23);
i') Ausführen eines anisotropen Ätzens der unteren Schicht längs der nicht bedeckten Teile (36, 31) durch die wenigstens eine Schutzmaske;
j') Abnehmen der Schutzmaske (34).

10. Verfahren (1) nach einem der vorhergehenden Ansprüche, **dadurch gekennzeichnet, dass** mehrere mikromechanische Verbundteile (41, 41') auf demselben Substrat (9, 9') gefertigt werden.

11. Verfahren (1) nach einem der vorhergehenden Ansprüche, **dadurch gekennzeichnet, dass** die leitenden Schichten (21, 23) ein Material auf Basis von dotiertem Silicium enthalten.
